# EUROPEAN PATENT APPLICATION

(11) **EP 4 333 069 A1**
(43) Date of publication of application: **06.03.2024**
(21) Application number: 22193338.5
(22) Date of filing: 31.08.2022
(51) Int. Cl.: H01L 29/06, H01L 29/732, H01L 29/861, H01L 29/872, H01L 29/66

(54) **VERTICAL SEMICONUCTOR DEVICE AND MANUFACUTING METHOD THEREFOR**

(71) Applicant: Nexperia B.V., 6534 AB Nijmegen (NL)
(72) Inventor: Berglund, Stefan, 22529 Hamburg (DE); Böttcher, Tim, 22529 Hamburg (DE); Holland, Steffen, 22529 Hamburg (DE); Bae, Seong-Woo, 22529 Hamburg (DE); Oelgeschlaeger, Detlef, 22529 Hamburg (DE)
(74) Representative: Pjanovic, Ilija

(57) **Abstract**

Aspects of the present disclosure generally relate to a vertical semiconductor device. Aspects of the present disclosure also relate to a method for manufacturing such vertical semiconductor device. The semiconductor device comprises a semiconductor body comprising a substrate and an epitaxial layer arranged on said substrate, wherein the epitaxial layer comprises a first semiconductor region of a first conductivity type, and a second semiconductor region of a second conductivity type different from the first conductivity type, wherein the second semiconductor region is arranged opposite to the substrate with respect to the first semiconductor region, and wherein, viewed in a first direction from the epitaxial layer to the substrate, the first semiconductor region and the second semiconductor region each extend across an entire area of the semiconductor body. The semiconductor device further comprises a trench arranged in the semiconductor body, wherein said trench extends through the second semiconductor region and at least partially into the first semiconductor region, thereby dividing the second semiconductor region into an inner portion and an outer portion that are mutually electrically isolated, and a first conductive contact arranged on the second semiconductor region and being configured to enable electrically accessing the inner portion.

## Description

### FIELD

Aspects of the present disclosure generally relate to a vertical semiconductor device. Aspects of the present disclosure also relate to a method for manufacturing such vertical semiconductor device.

### BACKGROUND

Semiconductor devices typically include an electronic component integrated on a semiconductor body of a certain technology, such as Silicon, Silicon Carbide, Gallium Arsenide, or the like. In vertical semiconductor devices, contrary to lateral semiconductor devices, current flows vertically from a top surface of the semiconductor body to a bottom surface thereof. In this manner relatively high drive capability can be achieved compared to lateral semiconductor devices.

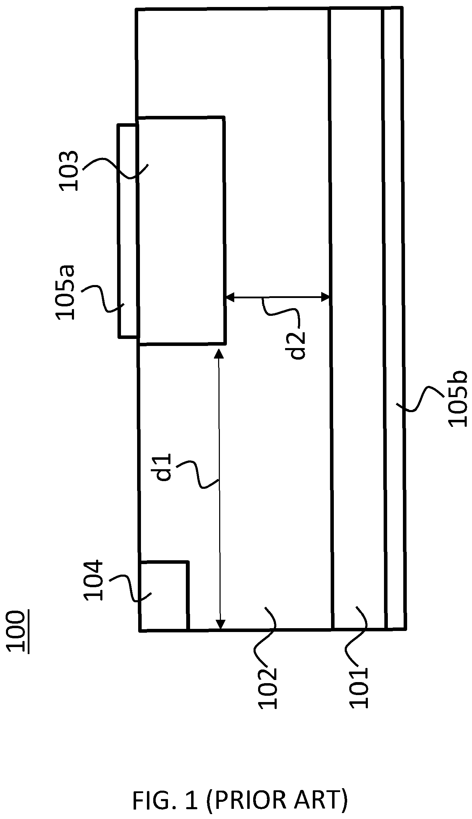

An example of a known vertical semiconductor device is a diode 100 as shown in FIG. 1. Diode 100 comprises a substrate 101 and an epitaxial layer grown on said substrate. The epitaxial layer comprises a first semiconductor region 102 of a first conductivity type and a second semiconductor region 103 of a second conductivity type structured into the epitaxial layer as a diffusion well. First semiconductor region 102 and second semiconductor region 103 together form a PN-junction. For example, the first conductivity type may be n-type and the second conductivity type may be p-type. In that case, first semiconductor region 102 acts as a cathode of diode 100 and second semiconductor region 103 acts as an anode of diode 100. In another example, the polarity of the conductivity types of first semiconductor region 102 and second semiconductor region 103 is reversed, thus also reversing their role as anode and cathode, respectively. Contacts 105a, 105b are arranged to enable electrically accessing the anode and cathode of diode 100.

Diode 100 further comprises a channel stopper region 104 of the second conductivity type arranged at a lateral edge of the epitaxial layer. In practice, when manufacturing a plurality of semiconductor devices on a wafer, channel stopper region 104 is arranged in a sawing lane in between respective portions of the wafer that will eventually form respective semiconductor devices. Channel stopper region 104 is typically arranged to prevent a parasitic channel from building up to neighboring dies of the wafer during a wafer test and to form a well-defined field in a field termination of diode 100.

Vertical semiconductor devices typically include a field termination around a periphery of the semiconductor body to prevent or limit premature lateral breakdown from occurring in reverse bias operation. As shown in FIG. 1, a known field termination approach is to increase a first distance d1 between second semiconductor region 103 and channel stopper region 104 such that it is greater than a second distance d2 between second semiconductor region 103 and substrate 101. In doing so, under reverse bias conditions, the junction between first semiconductor region 102 and second semiconductor region 103 will extend to substrate 101 before extending to the edge of the epitaxial layer, such that vertical breakdown occurs first.

A drawback of the known approach for preventing premature lateral breakdown is that the field termination may occupy a relatively large area of the semiconductor body which does not effectively contribute to the active area of the semiconductor device. This applies to diode 100 of FIG. 1, but also to other types of vertical semiconductor devices, such as bipolar junction transistors (BJT).

In addition, in the example shown in FIG. 1, the manufacturing method for diode 100 requires applying a mask layer, performing a lithography and etching step as well as implanting and driving in ions to form second semiconductor region 103 as a diffusion in the epitaxial layer. This can result in an increase in required thermal budget, process spread, energy consumption and, more generally, manufacturing costs for the semiconductor device.

### SUMMARY

Aspects of the present disclosure relate to a semiconductor device and manufacturing method therefor in which the abovementioned drawback(s) do not occur, or hardly so.

A summary of aspects of certain embodiments disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects and/or a combination of aspects that may not be set forth.

According to an aspect of the present disclosure, a vertical semiconductor device is provided. The semiconductor device comprises a semiconductor body comprising a substrate and an epitaxial layer arranged on said substrate. The epitaxial layer comprises a first semiconductor region of a first conductivity type, and a second semiconductor region of a second conductivity type different from the first conductivity type. The second semiconductor region is arranged opposite to the substrate with respect to the first semiconductor region. Furthermore, viewed in a first direction from the epitaxial layer to the substrate, the first semiconductor region and the second semiconductor region each extend across an entire area of the semiconductor body.

The semiconductor device according to an aspect of the present disclosure further comprises a trench arranged in the semiconductor body. The trench extends through the second semiconductor region and at least partially into the first semiconductor region, thereby dividing the second semiconductor region into an inner portion and an outer portion that are mutually electrically isolated. Furthermore, the semiconductor comprises a first conductive contact arranged on the second semiconductor region and being configured to enable electrically accessing the inner portion.

By employing the trench in accordance with the above that electrically insulates the inner portion and outer portion of the second semiconductor region, an area required for field termination can be significantly reduced. In addition, by using the trench, the second semiconductor region no longer needs to be structured into the epitaxial layer and can be arranged to extend across an entire area of the semiconductor body. In other words, the second semiconductor region can be arranged to fully cover the first semiconductor region. As a result, a manufacturing process for the semiconductor device can be realized in a more cost-efficient and time-efficient manner, as explained further below.

The epitaxial layer may be of the first conductivity type, and the second semiconductor region may be formed as a blanket-implant region in the epitaxial layer. Alternatively, the epitaxial layer may comprise a first epitaxial layer of the first conductivity type arranged on top of the substrate, said first epitaxial layer forming the first semiconductor region, and a second epitaxial layer of the second conductivity type arranged on top of the first epitaxial layer, said second epitaxial layer forming the second semiconductor region.

The semiconductor device may further comprises electrically insulating material arranged inside the trench. In an example, the electrically insulating material may comprise at least one of Silicon Oxide, Silicon Nitride and undoped polysilicon. The trench may completely filled with said electrically insulating material.

The trench may fully extend through both the first semiconductor region and the second semiconductor region.

A depth of the trench, taken in the first direction, may be greater than a width of the trench, taken in a second direction perpendicular to said first direction. For example, the depth may be at least two times greater than the width. In another example, the depth may be at least ten times greater than the width.

The trench may be formed as a closed-loop shape surrounding the inner portion.

The trench may be arranged closer to a periphery of the semiconductor body than to a center of the semiconductor body. In this manner, an active area of the semiconductor body can be maximized.

The semiconductor device may further comprise a second conductive contact configured to enable electrically accessing the first semiconductor region. For example, the second conductive contact may be arranged on the substrate opposite the first semiconductor region. In that case, the substrate may be of the first conductivity type and the second conductive contact may be electrically connected to the first semiconductor region through said substrate.

The first semiconductor region and the second semiconductor region may together form a PN-junction, and the semiconductor device may be a diode.

In some embodiments, the first conductive contact may form a Schottky contact with the second semiconductor region. To that end, the semiconductor device may include a Schottky diode.

The epitaxial layer may further comprise a third semiconductor region of the first conductivity type. The third semiconductor region may be spaced apart from the first semiconductor region by the second semiconductor region. In that case, the semiconductor device may be a bipolar junction transistor, BJT. For example, the second semiconductor region may form a base of the BJT, one of the first and third semiconductor region may form a collector of the BJT and another of the first and third semiconductor region may form an emitter of the BJT.

In a further embodiment, the semiconductor may comprise a third conductive contact configured to enable electrically accessing the third semiconductor region. For example, the third conductive contact may be arranged on the third semiconductor region at a same surface of the semiconductor body as the first conductive contact.

According to another aspect of the present disclosure, a method for manufacturing a vertical semiconductor device according to the above is provided. The method comprises the steps of: a) providing a semiconductor body comprising a substrate and an epitaxial layer arranged on said substrate, wherein the epitaxial layer comprises a first semiconductor region of a first conductivity type which, in a first direction from the epitaxial layer to the substrate, extends across an entire area of the semiconductor body; b) arranging a second semiconductor region of a second conductivity type different from the first conductivity type in the epitaxial layer opposite the substrate with respect to the first semiconductor region, wherein, in the first direction, the second semiconductor region extends across an entire area of the semiconductor body; c) forming a trench in the semiconductor body extending through the second semiconductor region and at least partially into the first semiconductor region, thereby dividing the second semiconductor region into an inner portion and an outer portion that are mutually electrically isolated; and d) forming a first conductive contact on the second semiconductor region, the first conductive contact being arranged to enable electrically accessing the inner portion.

By employing the trench, the second semiconductor region does not need to be structured and can be formed such as to fully extend across an entire area of the semiconductor body. For example, the second semiconductor region is arranged to fully cover the first semiconductor region. This obviates the need for arranging a masking layer and performing a lithography and etching step for arranging the second semiconductor region, which can reduce the thermal budget, process spread and energy consumption during the manufacturing method. The inner portion can be used as an active region of the semiconductor device and can be electrically accessed through the first conductive contact.
Step a) may comprise providing the substrate and growing the first semiconductor region on top of said substrate as a first epitaxial layer of the first conductivity type.
Step b) may comprise growing the second semiconductor region on top of the first semiconductor region as a second epitaxial layer of the second conductivity type.

Alternatively, step b) may comprise blanket-implanting the second semiconductor region in the epitaxial layer. For example, the blanket-implantation step can be followed by a drive-in step in a furnace to drive in the diffusion. Simultaneously with the drive-in step, an oxide can be produced for optional following lithography and structuring steps, such as forming a further semiconductor regions in a structured manner. In this way, a separate growing of such an oxide in a separate furnace step is not needed, thereby saving thermal budget.

Step c) may comprise performing an anisotropic etching step to form the trench. In this manner, a deep and narrow trench can be arranged to minimize an impact on the available active area of the semiconductor body while providing the function of electrically isolating the inner portion form the outer portion.

The method may further comprise arranging electrically insulating material inside the trench. For example, the electrically insulating material may comprise at least one of Silicon Oxide, Silicon Nitride and undoped polysilicon. The trench may be completely filled with said electrically insulating material.

The trench may be formed such that it fully extends through both the first semiconductor region and the second semiconductor region.

The trench may be formed such that a depth of said trench taken in the first direction is greater than a width of said trench taken in a second direction perpendicular to said first direction, for example at least two times greater, or in another example at least ten times greater.

The trench may be formed as a closed-loop shape surrounding the inner portion.

The trench may be arranged closer to a periphery of the semiconductor body than to a center of the semiconductor body.

The method may further comprise arranging a second conductive contact configured to enable electrically accessing the first semiconductor region. For example, the second conductive contact may be arranged on the substrate opposite the first semiconductor region. In that case, the substrate may be of the first conductivity type and the second conductive contact may be electrically connected to the first semiconductor region through said substrate.

The first semiconductor region and the second semiconductor region may together form a PN-junction, and the semiconductor device may be a diode.

In some embodiments, the first conductive contact may form a Schottky contact with the second semiconductor region. To that end, the semiconductor device may include a Schottky diode.

The method may further comprise a step of d) forming a third semiconductor region of the first conductivity type in the epitaxial layer, wherein the third semiconductor region is spaced apart from the first semiconductor region by the second semiconductor region. In that case, the semiconductor device may be a bipolar junction transistor, BJT. For example, the second semiconductor region may form a base of the BJT, one of the first and third semiconductor region may form a collector of the BJT and another of the first and third semiconductor region may form an emitter of the BJT.

Step d) may comprise arranging a mask layer on the semiconductor device and performing an ion implantation step to form the third semiconductor region. The mask layer may comprise an oxide material, preferably Silicon Oxide. Furthermore, if the second semiconductor region is formed using a blanket-implantation step, then the mask layer may be formed during a drive-in step following said blanket-implantation step.

The method may further comprise arranging a third conductive contact configured to enable electrically accessing the third semiconductor region. For example, the third conductive contact may be arranged on the third semiconductor region at a same surface of the semiconductor body as the first conductive contact.

### DESCRIPTION OF THE DRAWINGS

Next, the present disclosure will be described in more detail with reference to the appended drawings, wherein:
FIG. 1 is a cross-sectional view of a diode known in the art;
FIG. 2 is part of a cross-sectional view of a diode in accordance with an embodiment of the present disclosure;
FIG. 3 is part of a cross-sectional view of a bipolar junction transistor in accordance with an embodiment of the present disclosure; and
FIG. 4 is a flowchart for a manufacturing process of the semiconductor device in accordance with an embodiment of the present disclosure.

The present disclosure is described in conjunction with the appended figures. It is emphasized that, in accordance with the standard practice in the industry, various features are not drawn to scale. In fact, the dimensions of the various features may be arbitrarily increased or reduced for clarity of discussion.

In the appended figures, similar components and/or features may have the same reference label. Further, various components of the same type may be distinguished by following the reference label by a dash and a second label that distinguishes among the similar components. If only the first reference label is used in the specification, the description is applicable to any one of the similar components having the same first reference label irrespective of the second reference label.

Unless the context clearly requires otherwise, throughout the description and the claims, the words "comprise," "comprising," and the like are to be construed in an inclusive sense, as opposed to an exclusive or exhaustive sense; that is to say, in the sense of "including, but not limited to." As used herein, the terms "connected," "coupled," or any variant thereof means any connection or coupling, either direct or indirect, between two or more elements; the coupling or connection between the elements can be physical, logical, electromagnetic, or a combination thereof. Additionally, the words "herein," "above," "below," and words of similar import, when used in this application, refer to this application as a whole and not to any particular portions of this application. Where the context permits, words in the detailed description using the singular or plural number may also include the plural or singular number respectively. The word "or," in reference to a list of two or more items, covers all of the following interpretations of the word: any of the items in the list, all of the items in the list, and any combination of the items in the list.

The teachings of the technology provided herein can be applied to other systems, not necessarily the system described below. The elements and acts of the various examples described below can be combined to provide further implementations of the technology. Some alternative implementations of the technology may include not only additional elements to those implementations noted below, but also may include fewer elements.

These and other changes can be made to the technology in light of the following detailed description. While the description describes certain examples of the technology, and describes the best mode contemplated, no matter how detailed the description appears, the technology can be practiced in many ways. Details of the system may vary considerably in its specific implementation, while still being encompassed by the technology disclosed herein. As noted above, particular terminology used when describing certain features or aspects of the technology should not be taken to imply that the terminology is being redefined herein to be restricted to any specific characteristics, features, or aspects of the technology with which that terminology is associated. In general, the terms used in the following claims should not be construed to limit the technology to the specific examples disclosed in the specification, unless the detailed description section explicitly defines such terms. Accordingly, the actual scope of the technology encompasses not only the disclosed examples, but also all equivalent ways of practicing or implementing the technology under the claims.

To reduce the number of claims, certain aspects of the technology are presented below in certain claim forms, but the applicant contemplates the various aspects of the technology in any number of claim forms.

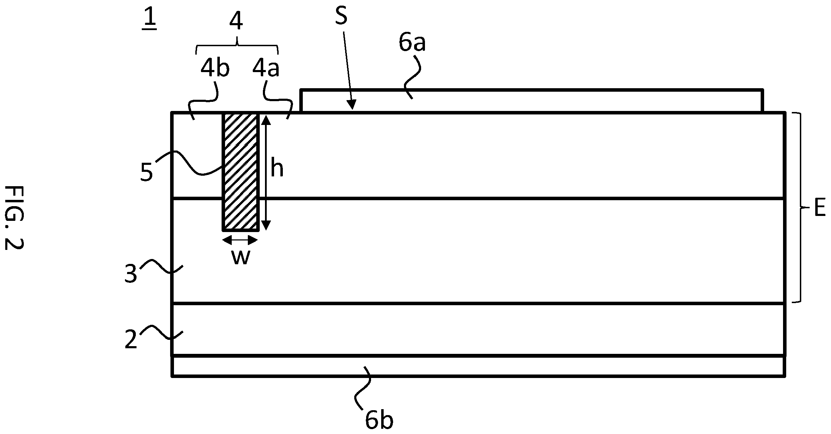

FIG. 2 shows part of a cross-sectional view of a semiconductor device 1 according to an embodiment of the present disclosure. Semiconductor device 1 comprises a semiconductor body including a substrate 2 and an epitaxial layer E on top of said substrate 2. Epitaxial layer E comprises a first semiconductor region 3 of a first conductivity type extending across an entire area of the semiconductor body, and a second semiconductor region 4 of a second conductivity type different from the first conductivity type that also extends across an entire area of the semiconductor body. In particular, both first semiconductor region 3 and second semiconductor region 4 extend across an entire area of the semiconductor body viewed in a direction from epitaxial layer E to substrate 2. In other words, first semiconductor region 3 fully covers substrate 2, and second semiconductor region 4 fully covers first semiconductor region 3.

The first conductivity type may correspond to an n-type doping, and the second conductivity type may correspond to a p-type doping. Alternatively, the first conductivity type may correspond to p-type doping and the second conductivity type may correspond to n-type doping. As a result, first semiconductor region 3 and second semiconductor region 4 together form a PN junction. To that end, semiconductor device 1 may form a diode or may at least realize a diode in its structure.

Semiconductor device 1 further comprises a trench 5 arranged in the semiconductor body and extending from a surface S thereof through second semiconductor region 4 and at least partially into first semiconductor region 3. As a result, trench 5 divides second semiconductor region 4 into an inner portion 4a and an outer portion 4b that are mutually electrically isolated. For example, trench 5 has a closed-loop shape surrounding inner portion 4a in the semiconductor body. A first conductive contact 6a is arranged on surface S and electrically contacts inner portion 4a. Inner portion 4a may thus be used as part of an active area of semiconductor device 1. With trench 5, an area occupied by field termination elements can be significantly reduced.

Here, it is noted that although FIG. 2 shows that trench 5 extends only partially into first semiconductor region 3, the present disclosure is not limited thereto. Trench 5 may also extend fully through first semiconductor region 3 and at least partially into substrate 2.

Trench 5 may be formed to be relatively deep and narrow. For example, a depth *h* of the trench may be at least two times greater than a width w of the trench. In a preferred embodiment, depth h is at least three times or even more than ten times greater than width w. A suitable exemplary pair of values may be about 2 µm for width w and about 4 µm for depth h. To that end, second semiconductor region 4 may have a corresponding depth of about 4 µm or less, though depth *h* of trench 5 may be adjusted accordingly based on the depth of second semiconductor region 4, or vice versa. Trench 5 may be formed closer to a lateral edge of the semiconductor body than to a center of the semiconductor body to increase a size of the active area and effectively use an area of semiconductor device 1.

In some embodiments, trench 5 may be at least partially filled with electrically insulating material, such as Silicon Oxide, Silicon Nitride, undoped polysilicon, or the like, and may comprise a combination of different materials. Said electrically insulating material may have a relatively high breakdown field strength to prevent or limit premature breakdown from occurring in semiconductor device 1. Trench 5 may be completely filled with said electrically insulating material. The electrically insulating material may be electrically isolated from terminals of semiconductor device 1 and may thus be disconnected from any external circuitry during operation.

A second conductive contact 6b may be arranged to electrically access first semiconductor region 3. For example, second conductive contact 6b may be electrically connected to first semiconductor region 3 via substrate 2. To that end, substrate 2 and first semiconductor region 3 may have a same conductivity type.

First conductive contact 6a and second conductive contact may each form a terminal of semiconductor device 1. Hence, during operation, current can flow from first conductive contact 6a to second conductive contact 6b via the semiconductor body, in particular via inner portion 4a, first semiconductor region 3 and substrate 2 in this example. In the embodiment shown in FIG. 2, semiconductor device 1 may be a diode of which the corresponding PN junction is formed by first semiconductor region 3 and inner portion 4a. In a further embodiment, first conductive contact 6a may form a Schottky contact with inner portion 4a. To that end, semiconductor device 1 may realize a diode in series with a Schottky diode between first conductive contact 6a and second conductive contact.

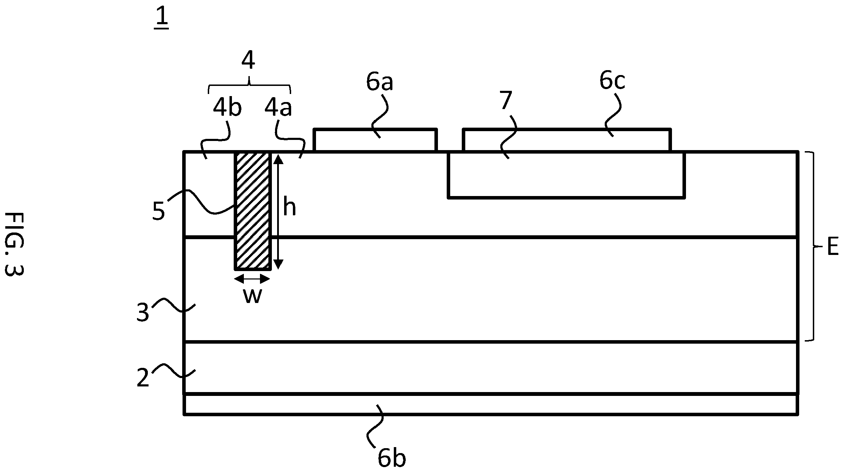

In FIG. 3, part of a cross-sectional view of semiconductor device 1 according to another embodiment of the present disclosure is shown. Semiconductor device 1 of FIG. 3 differs from that of FIG. 2 in that it further comprises a third semiconductor region 7 of the first conductivity type arranged in epitaxial layer E as a structured well, and a third conductive contact 6c for electrically accessing said third semiconductor region 7. In this embodiment, semiconductor device 1 may realize a BJT, with inner portion 4a forming a base region, one of first semiconductor region 3 and third semiconductor region 7 forming a collector region and another of first semiconductor region 3 and third semiconductor region 7 forming an emitter region.

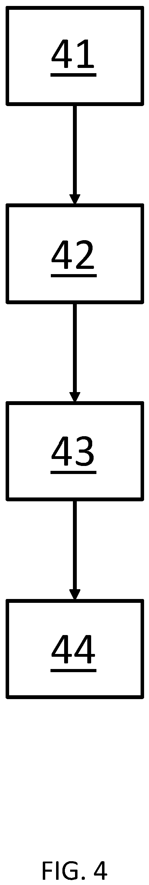

Next, a method for manufacturing semiconductor device 1 will be explained with reference to FIG. 4.

In operation 41, a semiconductor body is provided comprising substrate 2 and epitaxial layer E arranged on said substrate 2. Epitaxial layer E comprises first semiconductor region 3 of the first conductivity type which, in a first direction from epitaxial layer E to substrate 2, extends across an entire area of the semiconductor body. In other words, first semiconductor region 3 may fully cover an entire top surface of substrate 2, viewed in the first direction.

For example, the method may comprise providing substrate 2 and growing a first epitaxial layer of the first conductivity type on top of said substrate 2, said first epitaxial layer forming first semiconductor region 3.

Substrate 2, like first semiconductor region 3, may also be of the first conductivity type. Typically, first semiconductor region 3 may have a dopant concentration in a range of 1e13 - 1e16 cm⁻³, and substrate 2 may have a dopant concentration in a range of 1e18 - le20 cm⁻³.

In operation 42, second semiconductor region 4 of the second conductivity type is provided in epitaxial layer E opposite substrate 2 with respect to first semiconductor region 3. Similarly to first semiconductor region 3, second semiconductor region 4 extends across an entire area of the semiconductor body viewed in the first direction. In other words, second semiconductor region fully covers first semiconductor region 3, viewed in the first direction.

Providing second semiconductor region 4 may comprise growing a second epitaxial layer of the second charge type on top of first semiconductor region 3, said second epitaxial layer forming second semiconductor region 4. Alternatively, providing second semiconductor region 4 may comprise blanket-implanting ions in epitaxial layer E to thereby form second semiconductor region 4. This may be followed by a drive-in step using a furnace to drive in the implanted ions. Second semiconductor region 4 may have a dopant concentration in a range of 1e16 - 1e20 cm⁻³.

In operation 43, trench 5 is formed in the semiconductor body extending through second semiconductor region 4 and at least partially into first semiconductor region 3. Trench 5 divides second semiconductor region 4 into inner portion 4a and outer portion 4b that are mutually electrically isolated. Trench 5 may for example be formed using an anisotropic etching step. For example, a mask layer may be arranged and patterned, and a portion of the semiconductor may be etched away using a chemical etching process, after which the mask layer may be removed again. In some embodiments, after forming trench 5, electrically insulating material may be provided therein.

The mask layer for trench 5 may be at least partially formed during a drive-in step in the furnace when second semiconductor region 4 is formed using a blanket-implantation step. In that case, a patterning step may be performed on said formed mask layer. Alternatively, the mask layer is provided and patterned separately from other operations.

In operation 44, first conductive contact 6a may be formed on second semiconductor region 4 to enable electrically accessing inner portion 4a. For example, first conductive contact 3 may be comprised in a metal layer of a metal layer stack comprising at least one metal layer, which metal layer stack is arranged on the semiconductor body.

Second conductive contact 6b may be formed during or after operation 44, but may also be formed before operation 44. For example, second conductive contact 6b may already be provided at operation 41. Similarly to first conductive contact 6a, second conductive contact 6b may be formed in a metal layer of a metal layer stack comprising at least one metal layer.

First conductive contact 6a and, if applicable, third conductive contact 6c may for example be formed of one of aluminum, copper, an aluminum copper alloy, an aluminum, silicon and copper alloy, any Schottky metals combined with silicides and titanium, or the like. First and third conductive contact 6a, 6c need not be formed using the same material, however. Second conductive contact may comprise a metal layer assembly comprising at least one metal layer including one or more of gold, titanium, nickel, silver, gold arsenide alloy, gold germanium alloy, or the like. It is noted, however, that the above materials are merely provided as an example, and that present disclosure is not limited to a particular type of conductive contact. Suitable materials or alloys other than the ones mentioned above may be used instead, as will be appreciated by the skilled person.

In the above described method, semiconductor device 1 can be formed to be a diode. However, the present disclosure is not limited thereto, and may similarly relate to a method for manufacturing a semiconductor device including a BJT. To that end, the method may further comprise forming third semiconductor region 7 in epitaxial layer E as a well region in a structured manner. For example, the method may comprise providing and patterning a mask layer, followed by an ion implantation step and drive-in step to form third semiconductor region 7. The mask layer for third semiconductor region 7 may at least partially be the same mask layer as used for trench 5, or may be a separate mask layer. In an embodiment, the mask layer for third semiconductor region 7 is formed during the drive-in step for second semiconductor region 4 when second semiconductor region 4 is formed using a blanket-implantation step. In this manner, a step of providing a mask layer separately can be omitted. Third semiconductor region 7 may be formed after operation 43 for forming trench 5, or before operation 43 and after operation 42.

It will be appreciated by the skilled person that, although the method is described with respect to a single semiconductor device, the method may similarly extend to manufacturing a plurality of semiconductor devices consecutively or substantially simultaneously. For example, substrate 2 may form part of a wafer from which a plurality of semiconductor devices are singulated during the manufacturing process. For example, the singulation may be performed after completing the operations discussed above with reference to FIG. 4, though it may be performed earlier in the manufacturing process as well.

Semiconductor device 1 may be arranged in an electronic package, such as a molded electronic package. To that end, aspects of the present disclosure may also relate to an electronic package comprising semiconductor device 1. For example, the electronic package may comprise leads electrically connected to terminals of semiconductor device 1, such as first, second and third conductive contacts 6a-6c. Semiconductor device 1, or at least the semiconductor body thereof may be encapsulated in a package material, such as a body of solidified molding compound, as will be appreciated by a person skilled in the art.

The ensuing description above provides preferred exemplary embodiment(s) only, and is not intended to limit the scope, applicability, or configuration of the disclosure. Rather, the ensuing description of the preferred exemplary embodiment(s) will provide those skilled in the art with an enabling description for implementing a preferred exemplary embodiment of the disclosure, it being understood that various changes may be made in the function and arrangement of elements, including various modifications and/or combinations of features from different embodiments, without departing from the scope of the present disclosure as defined by the appended claims.

## Claims

1. A vertical semiconductor device, comprising:
a semiconductor body comprising a substrate and an epitaxial layer arranged on said substrate, wherein the epitaxial layer comprises a first semiconductor region of a first conductivity type, and a second semiconductor region of a second conductivity type different from the first conductivity type, wherein the second semiconductor region is arranged opposite to the substrate with respect to the first semiconductor region, and wherein, viewed in a first direction from the epitaxial layer to the substrate, the first semiconductor region and the second semiconductor region each extend across an entire area of the semiconductor body;
a trench arranged in the semiconductor body, wherein said trench extends through the second semiconductor region and at least partially into the first semiconductor region, thereby dividing the second semiconductor region into an inner portion and an outer portion that are mutually electrically isolated; and
a first conductive contact arranged on the second semiconductor region and being configured to enable electrically accessing the inner portion.

2. The semiconductor device according to claim 1, wherein the epitaxial layer is of the first conductivity type, and wherein the second semiconductor region is formed as a blanket-implant region in the epitaxial layer, or
wherein the epitaxial layer comprises:
a first epitaxial layer of the first conductivity type arranged on top of the substrate, said first epitaxial layer forming the first semiconductor region; and
a second epitaxial layer of the second conductivity type arranged on top of the first epitaxial layer, said second epitaxial layer forming the second semiconductor region.

3. The semiconductor device according to any of the previous claims, wherein the semiconductor device further comprises electrically insulating material arranged inside the trench,
wherein the electrically insulating material preferably comprises at least one of Silicon Oxide, Silicon Nitride and undoped polysilicon, and/or wherein the trench is preferably completely filled with said electrically insulating material.

4. The semiconductor device according to any of the previous claims, wherein at least one of the following applies:
the trench fully extends through both the first semiconductor region and the second semiconductor region;
a depth of the trench, taken in the first direction, is greater than a width of the trench, taken in a second direction perpendicular to said first direction, said depth preferably being at least two times greater than said width, more preferably at least three times greater;
the trench is formed as a closed-loop shape surrounding the inner portion;
the trench is arranged closer to a periphery of the semiconductor body than to a center of the semiconductor body.

5. The semiconductor device according to any of the previous claims, further comprising a second conductive contact configured to enable electrically accessing the first semiconductor region,
wherein, preferably:
the second conductive contact is arranged on the substrate opposite the first semiconductor region;
the substrate is of the first conductivity type; and
the second conductive contact is electrically connected to the first semiconductor region through said substrate.

6. The semiconductor device according to any of the previous claims, wherein the first semiconductor region and the second semiconductor region together form a PN-junction, and wherein the semiconductor device includes a diode; and/or
wherein the first conductive contact forms a Schottky contact with the second semiconductor region, and wherein the semiconductor device includes a Schottky diode.

7. The semiconductor device according to any of the previous claims, wherein the epitaxial layer further comprises a third semiconductor region of the first conductivity type, wherein the third semiconductor region is spaced apart from the first semiconductor region by the second semiconductor region,
wherein the semiconductor device is a bipolar junction transistor, BJT, the second semiconductor region forming a base of the BJT, one of the first and third semiconductor region forming a collector of the BJT and another of the first and third semiconductor region forming an emitter of the BJT,
wherein the semiconductor device preferably further comprises a third conductive contact configured to enable electrically accessing the third semiconductor region, wherein more preferably the third conductive contact is arranged on the third semiconductor region at a same surface of the semiconductor body as the first conductive contact.

8. A method for manufacturing a semiconductor device, comprising the steps of:
a) providing a semiconductor body comprising a substrate and an epitaxial layer arranged on said substrate, wherein the epitaxial layer comprises a first semiconductor region of a first conductivity type which, in a first direction from the epitaxial layer to the substrate, extends across an entire area of the semiconductor body;
b) arranging a second semiconductor region of a second conductivity type different from the first conductivity type in the epitaxial layer opposite the substrate with respect to the first semiconductor region, wherein, in the first direction, the second semiconductor region extends across an entire area of the semiconductor body;
c) forming a trench in the semiconductor body extending through the second semiconductor region and at least partially into the first semiconductor region, thereby dividing the second semiconductor region into an inner portion and an outer portion that are mutually electrically isolated; and
d) forming a first conductive contact on the second semiconductor region, the first conductive contact being arranged to enable electrically accessing the inner portion.

9. The method according to claim 8,
wherein step a) comprises providing the substrate and growing the first semiconductor region on top of said substrate as a first epitaxial layer of the first conductivity type; and/or
wherein step b) comprises growing the second semiconductor region on top of the first semiconductor region as a second epitaxial layer of the second conductivity type, or wherein step b) comprises blanket-implanting the second semiconductor region in the epitaxial layer; and/or
wherein step c) comprises performing an anisotropic etching step to form the trench.

10. The method according to claim 8 or 9, wherein the method further comprises arranging electrically insulating material inside the trench,
wherein the electrically insulating material preferably comprises at least one of Silicon Oxide, Silicon Nitride and undoped polysilicon, and/or wherein the trench is completely filled with said electrically insulating material.

11. The method according to any of the claims 8-10, wherein at least one of the following applies:
the trench is formed such that it fully extends through both the first semiconductor region and the second semiconductor region;
the trench is formed such that a depth of said trench taken in the first direction is greater than a width of said trench taken in a second direction perpendicular to said first direction, preferably at least three times greater;
the trench is formed as a closed-loop shape surrounding the inner portion;
the trench is arranged closer to a periphery of the semiconductor body than to a center of the semiconductor body.

12. The method according to any of the claims 8-11, wherein the method further comprises arranging a second conductive contact configured to enable electrically accessing the first semiconductor region, wherein the second conductive contact is preferably arranged on the substrate opposite the first semiconductor region, wherein the substrate is of the first conductivity type and wherein the second conductive contact is electrically connected to the first semiconductor region through said substrate.

13. The method according to any of the claims 8-12, wherein the first semiconductor region and the second semiconductor region together form a PN-junction, and wherein the semiconductor device includes a diode; and/or
wherein the first conductive contact forms a Schottky contact with the second semiconductor region, and wherein the semiconductor device includes a Schottky diode.

14. The method according to any of the claims 8-13, wherein the method further comprises:
d) forming a third semiconductor region of the first conductivity type in the epitaxial layer, wherein the third semiconductor region is spaced apart from the first semiconductor region by the second semiconductor region,
wherein the semiconductor device is a bipolar junction transistor, BJT, the second semiconductor region forming a base of the BJT, one of the first and third semiconductor region forming a collector of the BJT and another of the first and third semiconductor region forming an emitter of the BJT,
wherein the method preferably further comprises arranging a third conductive contact configured to enable electrically accessing the third semiconductor region, wherein the third conductive contact is preferably arranged on the third semiconductor region at a same surface of the semiconductor body as the first conductive contact.

15. The method according to claim 14, wherein step d) comprises arranging a mask layer on the semiconductor device and performing an ion implantation step to form the third semiconductor region,
wherein, preferably:
the mask layer comprises an oxide material, such as Silicon Oxide; and
in so far as step b) comprises blanket-implanting the second semiconductor region in the epitaxial layer, the mask layer is formed during a drive-in step following the blanket-implantation step.
